# EUROPÄISCHE PATENTSCHRIFT

(11) **EP 1 147 607 B1**
(45) Veröffentlichungstag und Bekanntmachung des Hinweises auf die Patenterteilung: **23.08.2006**
(21) Anmeldenummer: 99966809.8
(22) Anmeldetag: 01.12.1999
(51) Int. Cl.: H03K 17/16

(54) **VERFAHREN UND VORRICHTUNG ZUM ANSTEUERN EINER LEISTUNGSENDSTUFE**
METHOD AND DEVICE FOR CONTROLLING A POWER OUTPUT STAGE
PROCEDE ET DISPOSITIF DE COMMANDE D'UN ETAGE DE PUISSANCE

(30) Priorität: 02.12.1998 DE 19855604
(43) Veröffentlichungstag der Anmeldung: 24.10.2001
(73) Patentinhaber: SIEMENS AKTIENGESELLSCHAFT, 80333 München (DE)
(72) Erfinder: FALTER, Johann, D-93173 Wenzenbach (DE); ELLIOTT, Mark, D-93055 Regensburg (DE); BRANDO, Cyrille, F-31650 Saint Orens De Gammevi (FR)
(86) Internationale Anmeldenummer: PCT/DE1999/003816
(87) Internationale Veröffentlichungsnummer: WO 2000/033462

(56) Entgegenhaltungen:
- GB-A- 2 140 996
- GB-A- 2 318 467

## Beschreibung

Die Erfindung betrifft ein Verfahren zum Ansteuern eines induktiven Verbrauchers nach dem Oberbegriff des Patentanspruchs 1. Die Erfindung betrifft auch eine Vorrichtung zur Durchführung dieses Verfahrens.

Zur Ansteuerung induktiver Verbraucher werden Leistungsendstufen mit Transistoren, insbesondere MOSFET-Transistoren, als Leistungsschalter verwendet. Beim Abschalten der Transistoren muß die Energie des induktiven Verbrauchers entweder über Zenerung der Endstufe oder über eine Freilaufdiode abgebaut werden. Bei Lasten mit hoher induktiver Energie wird eine Freilaufdiode über der Last verwendet. Ein Nachteil solcher Endstufen, insbesondere getakteter Endstufen, ist, daß sie erhebliche elektromagnetische Störungen hervorrufen.

Eine bekannte Ursache dafür ist die schnelle Spannungsänderung am Verbindungspunkt zwischen Verbraucher und Leistungsschalter. Dieser Ursache wird beispielsweise bei Schaltungen mit MOSFET's durch hochohmige Ansteuerung des Steueranschlusses mittels eines Widerstandes begegnet.

Eine weitere Ursache für die hervorgerufenen elektromagnetischen Störungen ist die durch das Schalten bewirkte schnelle Änderung des durch den Leistungsschalter fließenden Stromes.

Aus US 4,661,766 ist eine Leistungsendstufe für einen induktiven Verbraucher mit Freilaufdiode bekannt, bei welcher die Änderungsgeschwindigkeit (current slew rate) des durch den Leistungsschalter oder durch den Freilaufzweig fließenden Stromes auf einen vorgegebenen Wert geregelt wird. Dadurch wird jedoch der Schaltvorgang, d.h., der Übergang vom Ausschaltzustand in den Einschaltzustand, oder umgekehrt, sehr verzögert.

Eine ähnliche Schaltung ist aus GB 2 140 996 A bekannt, welche ein Verfahren zum geregelten Schalten einer Last mittels Steuersignalen offenbart, bei welchem ein Leistungsschalter ab dem Beginn eines Steuersignals mit einem Ladestrom vorgegebener, großer Anstiegsgeschwindigkeit geladen wird, bis dieser Ladestrom einen ersten Schwellwert überschreitet, dann darauf folgend solange mit einem Ladestrom vorgegebener, kleiner Anstiegsgeschwindigkeit geladen wird, bis dieser Ladestrom einen zweiten Schwellwert erreicht, und anschließend mit einem Ladestrom vorgegebener, großer Anstiegsgeschwindigkeit weiter geladen wird. Die Anstiegsgeschwindigkeit des Ladestroms wird in Abhängigkeit der Anstiegsgeschwindigkeit des Laststroms geregelt. Der Entladevorgang erfolgt in umgekehrter Reihenfolge.

Es ist Aufgabe der vorliegenden Erfindung, ein Verfahren zum Ansteuern eines induktiven Verbrauchers anzugeben, durch welches die elektromagnetischen Störungen verringert und die Schaltverzögerung (delay time) sowie die Verlustleistung klein gehalten werden können. Aufgabe der Erfindung ist auch, eine Vorrichtung zur Durchführung dieses Verfahrens zu schaffen.

Diese Aufgabe wird erfindungsgemäß durch die in den Ansprüchen 1 und 3 genannten Merkmale gelöst.

Die erfindungsgemäße Schaltung bietet den Vorteil, daß die Stromänderungsgeschwindigkeit einfach und gerade nur so steil einstellbar ist, daß keine wesentlichen Störungen auftreten, dabei die Schaltverzögerung aber nur unwesentlich verlängert wird.

Nachstehend wird die Erfindung anhand einer Zeichnung im einzelnen beschrieben. Es zeigen:
- Figur 1:: ein Ausführungsbeispiel einer erfindungsgemäßen Leistungsendstufe,
- Figur 2:: ein Flußdiagramm über den Ablauf des erfindungsgemäßen Verfahrens,
- Figur 3:: ein Diagramm über den Verlauf der Spannungen und Ströme beim Einschalten des Verbrauchers, und
- Figur 4:: ein Diagramm über den Verlauf der Spannungen und Ströme beim Ausschalten des Verbrauchers.

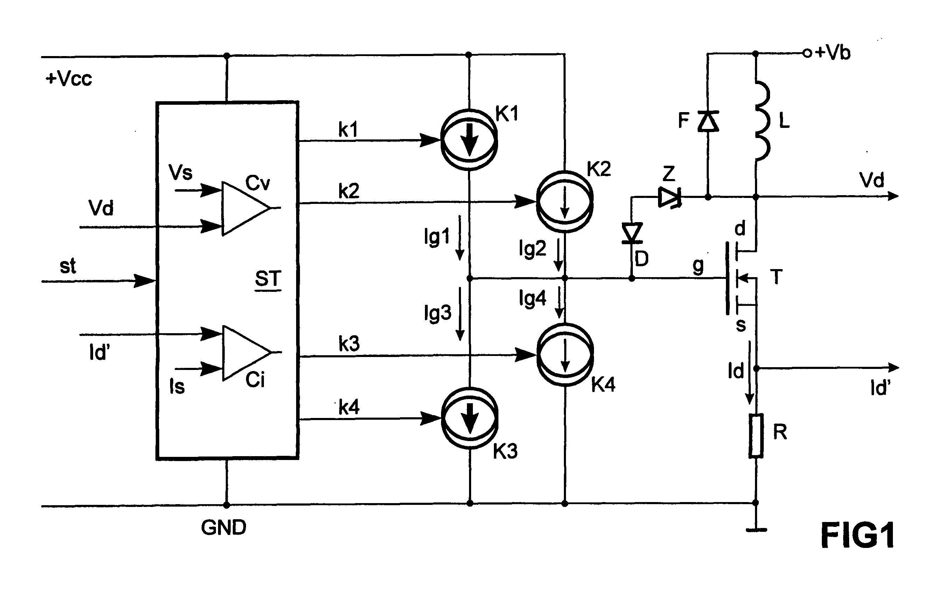

Die Erfindung wird anhand einer in einem Kraftfahrzeug eingesetzten, in einer integrierten Schaltung angeordneten, getakteten Leistungsendstufe zum Schalten eines induktiven Verbrauchers L mit Freilaufdiode F gemäß Figur 1 beschrieben. Die integrierte Leistungsendstufe kann beispielsweise in einem nicht dargestellten Motorsteuergerät angeordnet sein, von welchem sie die Steuersignale st zum getakteten Ein- und Ausschalten der induktiven Last L, beispielsweise eines Regelventils für die Abgasrückführung, erhält. Je nach dem eingestellten Taktverhältnis wird dieses Ventil mehr oder weniger aufgesteuert.

An den Polen +Vb und GND einer nicht dargestellten Spannungsquelle, beispielsweise der Fahrzeugbatterie, liegt eine Reihenschaltung des induktiven Verbrauchers L und eines durch einen MOSFET realisierten Leistungsschalters T.

Der Verbraucher L liegt zwischen dem Drainanschluß d des Leistungsschalters T und dem positiven Pol +Vb der Spannungsquelle. Der Sourceanschluß s ist über einen Meßwiderstand R mit dem negativen Pol GND verbunden. Parallel zum Verbraucher L ist eine zum Pluspol +Vb stromleitende Freilaufdiode F angeordnet. Zum Schutz des Leistungsschalters T ist zwischen dem Drainanschluß d und dem Gateanschluß g eine Reihenschaltung einer zum Drainanschluß d hin stromleitenden Zenerdiode Z und einer zum Gateanschluß g hin stromleitenden Diode D angeordnet.

Die Ansteuerung des Leistungsschalters T erfolgt über eine Steuerschaltung ST, in welcher aus den Steuersignalen st, einem Vergleichsergebnis der Drainspannung Vd mit einem vorgegebenen Spannungsschwellwert Vs und einem Vergleichsergebnis des Stromes, der durch den Leistungsschalter T fließt, im folgenden mit Drainstrom Id bezeichnet, mit einem vorgegebenen Stromschwellwert Is in Ansteuersignale k1 bis k4 für Konstantstromquellen K1 bis K4 umgewandelt werden. Der Spannungsschwellwert Vs ist so gewählt, daß er etwas unterhalb der Batteriespannung Vb liegt (beispielsweise Vb = 14V, Vs = 13V), und der Stromschwellwert Is soll etwa den zehnten bis zwanzigsten Teil des Drainstrom-Nennwertes Id betragen (beispielsweise Id = 2A, Is = 100mA).

Zur Durchführung des Spannungs- und Stromvergleichs sind in der Steuerschaltung ST zwei Komparatoren Cv und Ci vorgesehen, denen neben den vorgegebenen Schwellwerten Vs und Is die Drainspannung Vd und der Drainstrom Id (als am Meßwiderstand R abfallender Spannungswert Id') zugeführt werden.

Diese Konstantstromquellen K1 bis K4 erzeugen in eingeschaltetem Zustand konstante Lade- bzw. Entladeströme Ig1 bis Ig4, mit welchen das Gate des Leistungsschalters T geladen oder entladen wird.

Die Steuerschaltung ST und die Konstantstromquellen K1 bis K4 werden mit einer an den Polen +Vcc und GND abgreifbaren Versorgungsspannung Vcc betrieben, wobei die parallel zueinander liegenden Konstantstromquellen K1 und K2 zwischen dem Pluspol +Vcc und dem Gateanschluß g angeordnet sind und in eingeschaltetem Zustand zum Gateanschluß g hin gerichtete Ladeströme Ig1 und Ig2 einprägen, und die ebenfalls parallel zueinander liegenden Konstantstromquellen K3 und K4 zwischen dem Gateanschluß g und dem Minuspol GND angeordnet sind und in eingeschaltetem Zustand in Richtung vom Gateanschluß g weg gerichtete Entladeströme Ig3 und Ig4 einprägen.

Die Konstantstromquellen K1 und K3 erzeugen etwa um den Faktor 10 höhere Ströme Ig1, Ig3 (beispielsweise 2mA) als die Konstantstromquellen K2 und K4 (Ig2, Ig4), die je nach der gewünschten Drainstrom-Anstieg- bzw. Abfallgeschwindigkeit (current slew rate) hier beispielsweise 0.2mA erzeugen, was in Figur 1 durch dicke bzw. dünne, in die jeweilige Stromrichtung zeigende Pfeile in den Konstantstromquellen K1 bis K4 angedeutet ist.

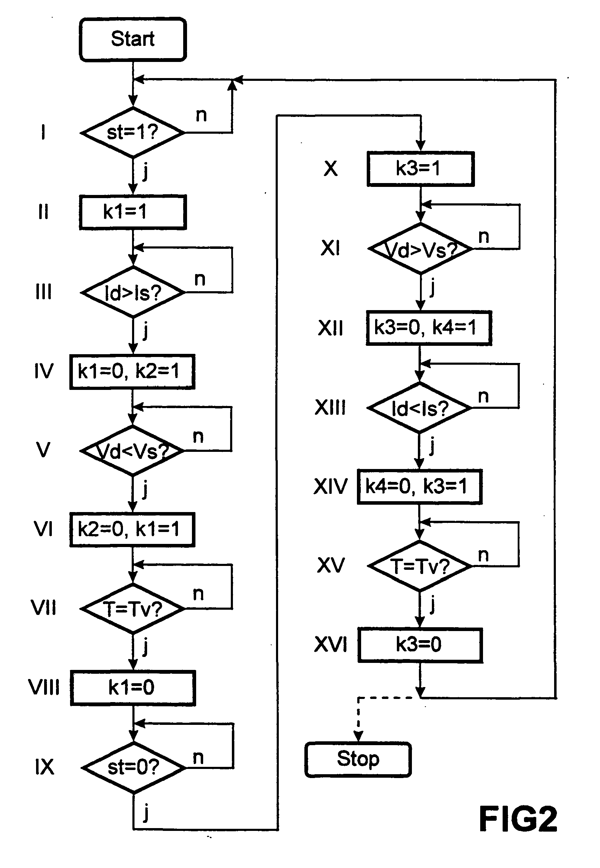

Im folgenden wird das Verfahren zum Schalten des induktiven Verbrauchers mittels der Leistungsendstufe anhand der Figuren 1 bis 4 beschrieben. In dem Flußdiagramm nach Figur 2 ist der Verfahrensablauf zum getakteten, fortlaufenden Ein- und Ausschalten der Last dargestellt. Auf die einzelnen, mit römischen Zahlen bezeichneten Verfahrensschritte wird in der folgenden Beschreibung durch in Klammern gesetzte römische Zahlen hingewiesen.

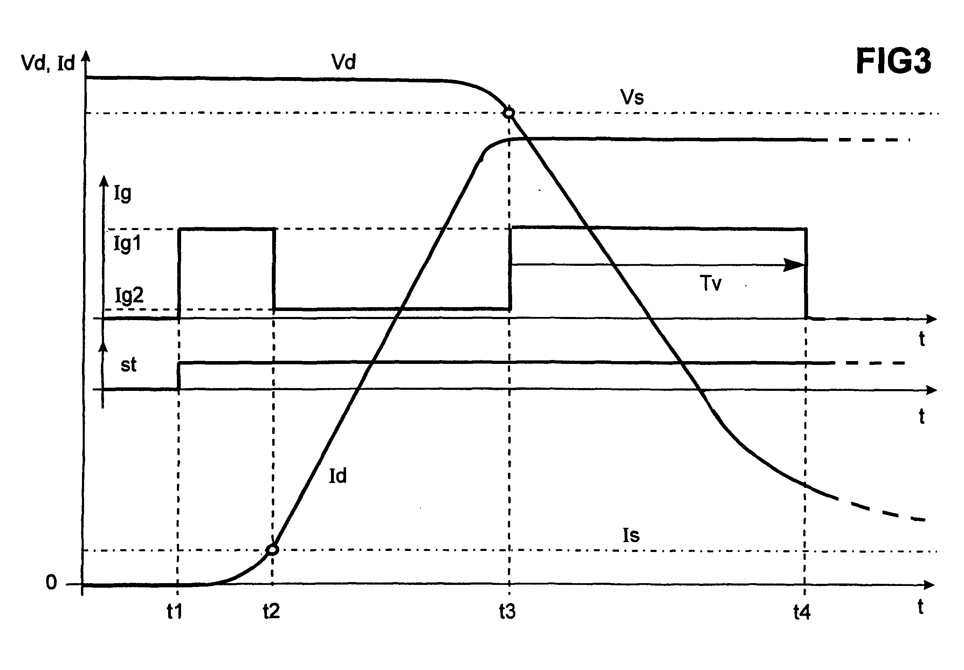

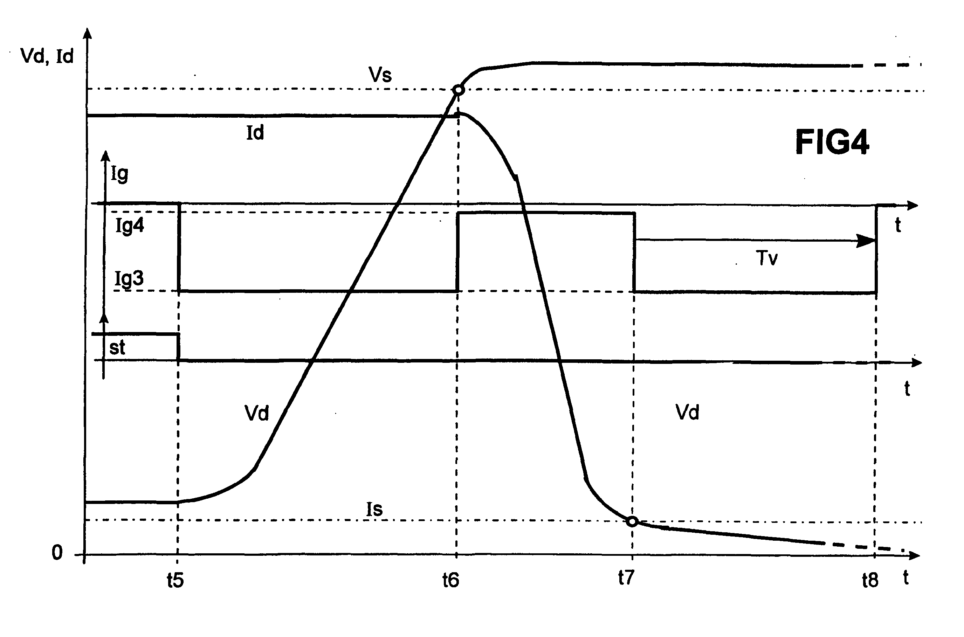

Figur 3 zeigt die Strom- und Spannungsverläufe beim Einschalten des Verbrauchers L, und Figur 4 die Strom- und Spannungsverläufe beim Ausschalten des Verbrauchers, wobei jeweils das Steuersignal st sowie der Ladestrom (mit positivem Vorzeichen in Figur 3), der Entladestrom (mit negativem Vorzeichen in Figur 4) und die daraus resultierenden Verläufe der Drainspannung Vd am Drainanschluß d und des Drainstromes Id aufgetragen sind. Des weiteren sind der Spannungsschwellwert Vs und der Stromschwellwert Is eingezeichnet.

Figuren 3 und 4 zeigen die Ströme und Spannungen während des Taktbetriebes, also nicht beim erstmaligen Einschalten der Last bei Betriebsbeginn.

Wenn ein Steuersignal st = 1 zum Einschalten der Last L zum Zeitpunkt t1 erscheint (I), wird von der Steuerschaltung ST ein Signal k1 zum Einschalten der Konstantstromquelle K1 gegeben (II), wodurch ein großer Ladestrom Ig1 zum Gate des Leistungsschalters T fließt, welches schnell geladen wird. Sobald zum Zeitpunkt t2 der daraufhin ansteigende Drainstrom Id den Schwellwert Is übersteigt (III), wird die Konstantstromquelle K1 abgeschaltet und an ihrer Stelle die Konstantstromquelle K2 mit einem Signal k2 eingeschaltet (IV), die nun ihrerseits das Gate mit einem kleinen Ladestrom Ig2 lädt.

Der Drainstrom Id steigt jetzt mit der gewünschten Anstiegsgeschwindigkeit auf seinen Sollwert, wodurch die Drainspannung Vd, die im nichtleitenden Zustand des Leistungsschalters T wegen des fließenden Freilaufstroms einen um die Spannung an der Freilaufdiode F größeren Wert als die Batteriespannung +Vb aufwies, abfällt und der Leistungsschalter T in den stromleitzustand übergeht.

Sobald die Drainspannung Vd zum Zeitpunkt t3 den Spannungsschwellwert Vs unterschreitet (V), wird die Konstantstromquelle K2 abgeschaltet und noch einmal für eine vorgegebene Dauer Tv die Konstantstromquelle K1 eingeschaltet (VI, VII). Durch diese Maßnahme wird der Leistungsschalter T mit großem Ladestrom Ig1 voll aufgesteuert und sein Drain-Source-Widerstand minimiert, wodurch am Leistungsschalter T im leitenden Zustand eine sehr kleine Spannung abfällt.

Nach Ablauf der vorgegebenen Dauer Tv wird zum Zeitpunkt t4 die Konstantstromquelle K1 wieder ausgeschaltet; die Last ist nun voll eingeschaltet(VIII). Dieser Zustand bleibt solange erhalten, bis das Steuersignal st zum Zeitpunkt t5 (Figur 4) verschwindet (IX), was bedeutet, daß die Last L abgeschaltet werden soll.

Mit dem Ende des Steuersignals st = 0 wird die Konstantstromquelle K3 eingeschaltet (X), wodurch ein großer Entladestrom Ig3 aus dem Gate des Leistungsschalters T abfließt. Die Drainspannung Vd steigt deshalb an. Wenn sie zum Zeitpunkt t6 den Spannungsschwellwert Vs überschreitet (XI), wird die Konstantstromquelle K3 abgeschaltet und die Konstantstromquelle K4 eingeschaltet (XII), wodurch der Drainstrom Id mit der gewünschten, dem Entladestrom Ig4 zugeordneten Stromabfallgeschwindigkeit kleiner wird und der Freilaufzweig den Strom übernimmt. Die Drainspannung Vd steigt wieder auf einen um die Spannung an der Freilaufdiode F größeren Wert als die Batteriespannung +Vb an.

Sobald der Drainstrom den Stromschwellwert Is unterschreitet (XIII), wird die Konstantstromquelle K4 abgeschaltet und erneut die Konstantstromquelle K3 für die vorgegebene Dauer Tv eingeschaltet (XIV), um nun das Gate mit großem Entladestrom Ig3 schnell auszuräumen und den Leistungsschalter T nichtleitend zu machen. Nach Ablauf der vorgegebenen Dauer Tv wird (XV) wird die Konstantstromquelle K3 ausgeschaltet (XVI), wodurch der Ausgangszustand wieder erreicht ist. Es kann nun weiter getaktet (I) oder die Ansteuerung der Last beendet werden.

Durch das abwechselnde Laden bzw. Entladen des Leistungsschalters mit großen bzw. kleinen Lade- bzw. Entladeströmen wird erreicht, daß die Ein- und Ausschaltverzögerungszeiten klein bleiben (die bei Ansteuerung nur mit einem der gewünschten Anstiegs- und Abfallgeschwindigkeit zugeordneten kleinen Lade- oder Entladestrom etwa zehn- bis zwanzigmal so lange dauern würden) und dennoch keine oder nur geringe elektromagnetische Störungen auftreten, da die Anstiegs- und Abfallgeschwindigkeiten des Drainstromes Id auf vorgegebene Werte begrenzt sind.

In diesem Ausführungsbeispiel sind die Beträge |Ig1| = |Ig3|, |Ig2| = |Ig4| und |Tv| (beim Laden) = |Tv| (beim Entladen) jeweils gleich groß gewählt. Diese Größen können jedoch, den Erfordernissen angepaßt, auch unterschiedlich groß gewählt werden.

## Patentansprüche

1. Verfahren zum Ansteuern einer Leistungsendstufe zum Schalten einer mit einem MOSFET-Leistungsschalter (T) in Reihenschaltung an den Polen (+Vb, GND) einer Spannungsquelle liegenden Last (L) mittels Steuersignalen (st),
**dadurch gekennzeichnet,**
**daß** der MOSFET-Leistungsschalter (T)
- ab dem Beginn eines Steuersignals (st) mit einem vorgegebenen, großen Ladestrom (Ig1) geladen wird, bis der Drainstrom (Id) einen vorgegebenen Stromschwellwert (Is) überschreitet (t1-t2),
- dann darauf folgend solange mit einem vorgegebenen, kleinen Ladestrom (Ig2) geladen wird, bis die Drainspannung (Vd) einen vorgegebenen Spannungsschwellwert (Vs) unterschreitet (t2-t3),
- anschließend für eine vorgegebene Ladedauer (Tv) mit dem vorgegebenen, großen Ladestrom (Ig1) weitergeladen wird (t3-t4), und
- ab dem Ende des Steuersignals (st) mit einem vorgegebenen, großen Entladestrom (Ig3) entladen wird, bis die Drainspannung (Vd) den vorgegebenen Spannungsschwellwert (Vs) überschreitet (t5-t6),
- dann darauffolgend solange mit einem vorgegebenen, kleinen Entladestrom (Ig4) entladen wird, bis der Drainstrom (Id) den vorgegebenen Stromschwellwert (Is) unterschreitet (t6-t7), und
- anschließend für eine vorgegebene Entladedauer (Tv) mit dem vorgegebenen, großen Entladestrom (Ig3) entladen wird (t7-t8).

2. Verfahren nach Anspruch 1, **dadurch gekennzeichnet, daß** die maximale Anstiegsgeschwindigkeit des Drainstroms (Id) vom Wert des kleinen Ladestroms (Ig2) und seine Abfallgeschwindigkeit vom Wert des kleinen Entladestroms (Ig4) bestimmt wird.

3. Vorrichtung zur Durchführung des Verfahrens nach Anspruch 1, **dadurch gekennzeichnet,**
- **daß** zwischen den Pluspol (+Vcc) einer Versorgungsspannung und den Gateanschluß (g) des MOSFET-Leistungsschalters (T) eine Konstantstromquelle (K1) für einen großen Ladestrom (Ig1) und parallel dazu eine Konstantstromquelle (K2) für einen kleinen Ladestrom (Ig2) geschaltet sind,
- **daß** zwischen den Gateanschluß (g) des MOSFET-Leistungsschalters (T) und den Minuspol (GND) der Versorgungsspannung eine Konstantstromquelle (K3) für einen.großen Entladestrom (Ig3) und parallel dazu eine Konstantstromquelle (K4) für einen kleinen Entladestrom (Ig4) geschaltet sind, und
- **daß** eine an einer Versorgungsspannung (Vcc) betriebene Steuerschaltung (ST) vorgesehen ist, von deren Schaltsignalen (k1 bis k4) die Konstantstromquellen (K1 bis K4), abhängig von
- den Steuersignalen (st),
- dem Verhältnis Vd>Vs oder Vd<Vs der Drainspannung (Vd) zu einem vorgegebenen Spannungsschwellwert (Vs),
- dem Verhältnis Id>Is oder Id<Is des den Leistungsschalter (T) durchfließenden Drainstromes (Id) zu einem vorgegebenen Stromschwellwert (Is), und
- wenigstens einer vorgegebenen Zeitdauer (Tv), ein- und ausgeschaltet werden.

## Claims

1. Method of driving a power output stage to switch a load (L) connected in series with a MOSFET circuit breaker (T) across the terminals (+Vb, GND) of a voltage source by means of control signals (st),
**characterized in that**
the MOSFET circuit breaker (T)
- from the start of a control signal (st), is charged with a predefined, high charging current (Ig1) until the drain current (Id) exceeds a predefined current threshold (Is) (t1-t2),
- it is then charged with a predefined, small charging current (Ig2) until the drain voltage (Vd) falls below a predefined voltage threshold (Vs) (t2-t3),
- then, for a predefined charging period (Tv) it is charged further with the predefined, high charging current (Ig1) (t3-t4), and
- from the end of the control signal (st), it is discharged with a predefined, high discharge current (Ig3) until the drain voltage (Vd) exceeds the predefined voltage threshold (Vs) (t5-t6),
- it is then discharged with a predefined, small discharge current (Ig4) until the drain current (Id) falls below the predefined current threshold (Is) (t6-t7), and
- then, for a predefined discharge period (Tv), it is discharged with the predefined, high discharge current (Ig3) (t7-t8).

2. Method according to Claim 1, **characterized in that** the maximum rate of rise of the drain current (Id) is determined by the value of the small charging current (Ig2), and its rate of fall is determined by the value of the small discharge current (Ig4).

3. Device for implementing the method according to Claim 1, **characterized**
- **in that** between the positive terminal (+Vcc) of a supply voltage and the gate terminal (g) of the MOSFET circuit breaker (T), there is connected a constant current source (K1) for a high charging current (Ig1) and, in parallel therewith, a constant current source (K2) for a small charging current (Ig2),
- **in that**, between the gate terminal (g) of the MOSFET circuit breaker (T) and the negative terminal (GND) of the supply voltage, there is connected a constant current source (K3) for a high discharge current (Ig3) and, in parallel therewith, a constant current source (K4) for a small discharge current (Ig4), and
- **in that** a control circuit (ST) operated on a supply voltage (Vcc) is provided, whose switching signals (k1 to k4) switch the constant current sources (K1 to K4) on and off, as a function of
- the control signals (st),
- the ratio Vd>Vs or Vd<Vs between the drain voltage (Vd) and a predefined voltage threshold (Vs),
- the ratio Id>Is or Id<Is of the drain current (Id) flowing through the circuit breaker (T) and a predefined current threshold (Is), and
- at least one predefined time period (Tv).

## Revendications

1. Procédé pour enclencher un étage final de puissance pour commuter, au moyen de signaux de commande (st), une charge (L) située dans un circuit en série, avec un commutateur de puissance MOSFET (T), aux pôles (+Vb, GND) d'une source de tension,
**caractérisé en ce que**
le commutateur de puissance MOSFET (T),
- à partir du début d'un signal de commande (st) est chargé avec un grand courant de charge (Ig1) prédéfini, jusqu'à ce que le courant de drain (Id) dépasse une valeur de seuil de courant (Is) prédéfinie, (t1-t2),
- à la suite de quoi, la charge est continuée avec un petit courant de charge (Ig2) prédéfini, jusqu'à ce que la tension de drain (Vd) devienne inférieure à une valeur de seuil prédéfinie (Vs) de la tension, (t2-t3),
- ensuite, la charge est continuée, pour une durée de charge (Tv) prédéfinie, avec le grand courant de charge (Ig1), (t3-t4), et
- à partir de la fin du signal de commande (st), on effectue la décharge avec un grand courant de décharge (Ig3), prédéfini, jusqu'à ce que la tension de drain (Vd) dépasse la valeur de seuil prédéfinie (Vs) de la tension, (t5-t6),
- à la suite de quoi, la décharge est continuée avec un petit courant de décharge (Ig4) prédéfini, jusqu'à ce que le courant de drain (Id) devienne inférieur à la valeur de seuil prédéfinie (Is) du courant, (t6-t7), et
- ensuite, la décharge est continuée, pour une durée de décharge (Tv) prédéfinie, avec le grand courant de décharge (Ig3), prédéfini, (t7-t8).

2. Procédé suivant la revendication 1, **caractérisé en ce que** la vitesse maximale de croissance du courant de drain (Id) est déterminée par la valeur du petit courant de charge (Ig2) et sa vitesse de décroissance par la valeur du petit courant de décharge (Ig4).

3. Dispositif pour l'exécution du procédé suivant la revendication 1, **caractérisé**
- **en ce qu'**entre le pôle positif (+Vcc) d'une tension d'alimentation et le raccordement de la porte (g) du commutateur de puissance MOSFET (T), est montée dans le circuit une source de courant constant (K1) pour un grand courant de charge (Ig1) et, parallèlement à elle, est montée une source de courant constant (K2) pour un petit courant de charge (Ig2),
- **en ce qu'**entre le raccordement de la porte (g) du commutateur de puissance MOSFET (T) et le pôle moins (GND) de la tension d'alimentation, est montée dans le circuit une source de courant constant (K3) pour un grand courant de décharge (Ig3) et, parallèlement à elle, est montée dans le circuit une source de courant constant (K4) pour un petit courant de décharge (Ig4), et
- **en ce qu'**il est prévu un circuit de commande (ST), entraîné sur une tension d'alimentation (Vcc), circuit dont les sources de courant constant (K1 à K4) sont enclenchées et déclenchées par les signaux de commutation (k1 à k4) en fonction:
- des signaux de commande (st),
- du rapport Vd>Vs ou Vd<Vs de la tension de drain (Vd) par rapport à une valeur prédéfinie (Vs) de la tension,
- du rapport Id>Is ou Id<Is du courant de drain (Id) traversant le commutateur de puissance (T), par rapport à une valeur de seuil prédéfinie (Is) du courant, et
- d'au moins une durée prédéfinie (Tv).
